# EUROPEAN PATENT APPLICATION

(11) **EP 4 692 827 A1**
(43) Date of publication of application: **11.02.2026**
(21) Application number: 24832400.6
(22) Date of filing: 25.06.2024
(51) Int. Cl.: G01R 31/396, G01R 31/371, G01R 31/367, G01R 31/36, G07C 5/02, G07C 5/00, G07C 5/08, B60L 3/12, B60L 58/10

(54) **VEHICLE ASSISTANCE DEVICE AND METHOD FOR OPERATING VEHICLE ASSISTANCE DEVICE**

(30) Priority: 29.06.2023 KR 20230083923; 15.11.2023 KR 20230157900
(71) Applicant: LG Energy Solution, Ltd., Seoul 07335 (KR)
(72) Inventor: JUNG, Geon, Daejeon 34122 (KR)
(74) Representative: Plasseraud IP
(86) International application number: PCT/KR2024/008804
(87) International publication number: WO 2025/005622

(57) **Abstract**

According to some embodiments disclosed in the present document, a vehicle assistance device includes a communication module configured to collect battery data of a vehicle from a data port of the vehicle, a controller configured to manage the battery data and provide at least one of an image acquisition function of acquiring images of surroundings of the vehicle and a route guide function of guiding a traveling route of the vehicle, and a storage configured to store at least some of the battery data.

## Description

### [TECHNICAL FIELD]

### CROSS-REFERENCE TO RELATED APPLICATION

The present application claims priority to and the benefit of Korean Patent Application No. 10-2023-0157900 filed with the Korean Intellectual Property Office on November 15, 2023, and Korean Patent Application No. 10-2023-0083923 filed with the Korean Intellectual Property Office on June 29, 2023, the entire contents of which are incorporated herein by reference.

### TECHNICAL FIELD

Embodiments disclosed in the present document relate to a vehicle assistance device and a method of operating the same.

### [BACKGROUND ART]

Recently, research and development have been actively conducted on secondary batteries. In this case, the secondary batteries may be chargeable/dischargeable batteries and interpreted as including Ni/Cd batteries and Ni/MH batteries in the related art and the recent lithium-ion batteries. Among the secondary batteries, the lithium-ion batteries may have higher energy density than Ni/Cd batteries and Ni/MH batteries in the related art and be manufactured to be small in scale and lightweight, such that the lithium-ion batteries may have high utilization in relation to power sources for mobile devices. Recently, the range of use of the lithium-ion batteries has expanded to power sources for electric vehicles, and the lithium-ion batteries are attracting attention as next-generation energy storage media.

In the event of an accident such as an internal short circuit of a secondary battery in an electric vehicle, the accident may cause a fire. Therefore, it may be important to analyze a cause of a battery accident. In order to analyze the cause, battery data acquired before and after the accident may be required. Therefore, there is a need for a method capable of obtaining data before and after the battery accident in the vehicle.

### [DISCLOSURE]

### [TECHNICAL PROBLEM]

An object of embodiments disclosed in the present document is to provide a vehicle assistance device, which is capable of obtaining battery data at time points before and after the occurrence of a battery accident in a vehicle, and a method of operating the same.

Technical problems of the embodiments disclosed in the present document are not limited to the aforementioned technical problems, and other technical problems, which are not mentioned above, may be clearly understood by those skilled in the art from the following descriptions.

### [TECHNICAL SOLUTION]

According to some embodiments disclosed in the present document, a vehicle assistance device includes a communication module configured to collect battery data of a vehicle from a data port of the vehicle, a controller configured to manage the battery data and provide at least one of an image acquisition function of acquiring images of surroundings of the vehicle and a route guide function of guiding a traveling route of the vehicle, and a storage configured to store at least some of the battery data.

According to some embodiments, the controller may be configured to determine whether an event related to an abnormal operation of the battery occurs on the basis of the battery data, and the controller may be configured to record the battery data for a time section including an event occurrence time point in the storage.

According to some embodiments, the controller may be configured to determine whether a warning event or an emergency event related to the battery occurs on the basis of a level of the abnormal operation, and the controller may be configured to record the battery data for a time section including an emergency event occurrence time point when the emergency event occurs.

According to some embodiments, the controller may be configured to compare a measurement value of a battery variable according to the battery data with a plurality of threshold values and determine a level of the abnormal operation as any one of a normal level, a warning level, and an emergency level, and the controller may be configured to determine that the warning event or the emergency event occurs in response to the warning level or the emergency level.

According to some embodiments, the controller may be configured to calculate an emergency lower limit value, an emergency upper limit value, a warning lower limit value, and a warning upper limit value by multiplying a normal reference value of the battery variable by first to fourth parameters, the controller may be configured to determine that the emergency event occurs when the measurement value of the battery variable is larger than the emergency lower limit value or smaller than the emergency lower limit value, and the controller may be configured to determine that the warning event occurs when the measurement value of the battery variable is larger than the warning lower limit value or smaller than the warning lower limit value.

According to some embodiments, the controller may be configured to back up the battery data for the time section including the emergency event occurrence time point to a management server of the vehicle assistance device and a mobile terminal of a driver registered in the vehicle assistance device when the emergency event occurs.

According to some embodiments, the vehicle assistance device may further include: a display configured to display a detailed description of the abnormal operation and an advisory message to a driver together with battery monitoring information according to the battery data when the warning event or the emergency event occurs.

According to some embodiments, the controller may be configured to receive information on the detailed description from a management module of the battery, and the controller may be configured to display, to the driver, identification information of a battery unit of the battery, in which the abnormal operation occurs, a type of battery variable related to the abnormal operation, and a difference between a measurement value of the battery variable and a normal value on the basis of the information on the detailed description.

According to some embodiments, the controller may be configured to derive detailed management information of the battery including state-of-charge (SOC) information, state-of-health information, and a state score on the basis of the battery data by means of battery management software provided from a management server of the vehicle assistance device and display the detailed management information on the display.

According to some embodiments, the controller may be configured to provide the battery data to a management server of the vehicle assistance device and display, on the display, detailed management information of the battery including state of charge (SOC) information, state-of-health information, and a state score provided from the management server.

According to some embodiments disclosed in the present document, a method of operating a vehicle assistance device includes: collecting battery data of a vehicle from a data port of the vehicle; providing at least one of an image acquisition function of acquiring images of surroundings of the vehicle and a route guide function of guiding a traveling route of the vehicle; managing the battery data; and storing at least some of the battery data.

According to some embodiments, the storing of at least some of the battery data may include: determining whether an event related to an abnormal operation of the battery occurs on the basis of the battery data; and recording the battery data for a time section including an event occurrence time point in the storage.

According to some embodiments, the recording of the battery data may include: determining whether a warning event or an emergency event related to the battery occurs on the basis of a level of the abnormal operation; and recording the battery data for a time section including an emergency event occurrence time point when the emergency event occurs.

According to some embodiments, the determining of whether the warning event or the emergency event occurs may include: comparing a measurement value of a battery variable according to the battery data with a plurality of threshold values and determining a level of the abnormal operation as any one of a normal level, a warning level, and an emergency level; and determining that the warning event or the emergency event occurs in response to the warning level or the emergency level.

According to some embodiments, the determining of whether the warning event or the emergency event occurs may include: calculating an emergency lower limit value, an emergency upper limit value, a warning lower limit value, and a warning upper limit value by multiplying a normal reference value of the battery variable by first to fourth parameters; and determining that the emergency event occurs when the measurement value of the battery variable is larger than the emergency lower limit value or smaller than the emergency lower limit value, and determining that the warning event occurs when the measurement value of the battery variable is larger than the warning lower limit value or smaller than the warning lower limit value.

According to some embodiments, the recording of the battery data may include backing up the battery data for the time section including the emergency event occurrence time point to a management server of the vehicle assistance device and a mobile terminal of a driver registered in the vehicle assistance device when the emergency event occurs.

According to some embodiments, the method may further include: displaying a detailed description of the abnormal operation and an advisory message to a driver together with battery monitoring information according to the battery data when the warning event or the emergency event occurs.

According to some embodiments, the displaying may include: receiving information on the detailed description from a management module of the battery; and displaying, to the driver, identification information of a battery unit of the battery, in which the abnormal operation occurs, a type of battery variable related to the abnormal operation, and a difference between a measurement value of the battery variable and a normal value on the basis of the information on the detailed description.

According to some embodiments, the displaying may include: deriving detailed management information of the battery including state of charge (SOC) information, state-of-health information, and a state score on the basis of the battery data by means of battery management software provided from a management server of the vehicle assistance device; and displaying the detailed management information on the display.

According to some embodiments, the displaying may include: providing the battery data to a management server of the vehicle assistance device; and displaying, on the display, detailed management information of the battery including state of charge (SOC) information, state-of-health information, and a state score provided from the management server.

### [ADVANTAGEOUS EFFECTS]

According to the embodiments disclosed in the present document, it is possible to provide the vehicle assistance device, which is capable of obtaining the battery data at the time points before and after the occurrence of a battery accident in the vehicle, and the method of operating the same.

The technical effects according to the embodiments disclosed in the present document are not limited to the aforementioned effects, and other effects, which are not mentioned above, will be clearly understood by those skilled in the art from the disclosure of the present document.

### [DESCRIPTION OF DRAWINGS]

FIG. 1 is a view illustrating elements constituting a vehicle assistance system according to some embodiments.
FIG. 2 is a view illustrating the elements constituting the vehicle assistance device according to some embodiments.
FIG. 3 is a view illustrating a structure in which the vehicle assistance device according to some embodiments is connected to a vehicle.
FIG. 4 is a view illustrating a black box function of the vehicle assistance device according to some embodiments.
FIG. 5 is a view illustrating a navigation function of the vehicle assistance device according to some embodiments.
FIG. 6 is a view illustrating a method of displaying battery monitoring information and detailed management information on a display of the vehicle assistance device according to some embodiments.
FIG. 7 is a view illustrating a method of displaying a detailed description of an abnormal operation and an advisory message on the display of the vehicle assistance device according to some embodiments.
FIG. 8 is a view illustrating a process of determining a level of the abnormal operation by comparing a measurement value of a battery variable with a plurality of threshold values according to some embodiments.
FIG. 9 is a view illustrating steps constituting a method of operating the vehicle assistance device according to some embodiments.

### [MODE FOR INVENTION]

Hereinafter, embodiments disclosed in the present document will be described with reference to the accompanying drawings. However, the description of the embodiments is not intended to limit the disclosure of the present document to the particular embodiments, but it should be understood that the embodiments are to cover all modifications, equivalents, and/or alternatives of the embodiments disclosed in the present document.

The embodiments of the present document and the terms used in the embodiments are not intended to limit the technical features disclosed in the present document to the particular embodiments and should be understood as including various alterations, equivalents, or alternatives of the corresponding embodiments. In connection with the description of the drawings, the same or similar reference numerals may be used for the similar components. A singular form of a noun corresponding to an item may include one or more of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Unless specifically stated to the contrary, the terms such as "1st," "2nd," "first," "second," "A," "B," "(a)," or "(b)" may be used to simply distinguish a corresponding component from another component and does not limit the corresponding components in other aspect (e.g., importance or order).

In the present document, when an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly or wirelessly), or indirectly (e.g., via a third element).

A method according to various embodiments disclosed in the present document may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to the embodiments disclosed in the present document, each constituent element (e.g., module or program), among the above-mentioned constituent elements, may include a single object or a plurality of objects, and some of the plurality of objects may be disposed separately in different constituent elements. According to the embodiments disclosed in the present document, one or more constituent elements, among the above-mentioned constituent elements, or operations may be omitted, or one or more other constituent elements or operations may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. According to the embodiments disclosed in the present document, operations performed by the module, the program, or another component may be carried out sequentially, in parallel, repeatedly, or heuristically, or one or more of the operations may be executed in a different order or omitted, or one or more other operations may be added.

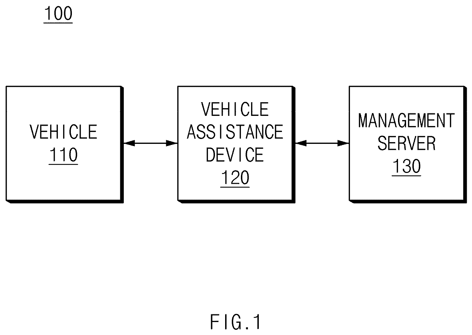

FIG. 1 is a view illustrating elements constituting a vehicle assistance system according to some embodiments.

With reference to FIG. 1, a vehicle assistance system 100 may include a vehicle 110, a vehicle assistance device 120, and a management server 130. However, the present disclosure is not limited thereto. Some components may be excluded from the vehicle assistance system 100, or other universal components may be further included in the vehicle assistance system 100.

The vehicle assistance system 100 may include a system configured to provide an assistance function to the vehicle 110 through the vehicle assistance device 120 and the management server 130. According to the embodiment, the vehicle assistance system 100 may provide functions of managing and recording battery data of the vehicle 110. The vehicle 110 and the vehicle assistance device 120 may be connected through an OBD (on-board diagnostics) connector or the like. The vehicle assistance device 120 and the management server 130 may be connected through wired/wireless communication networks.

The vehicles 110 may include an electric vehicle (EV) or a hybrid electric vehicle (HEV) that uses a battery as driving energy. The vehicle 110 may provide vehicle data to the outside through a data port such as an OBD terminal. The vehicle data may include the battery data related to the battery of the vehicle 110.

The vehicle assistance device 120 may perform operations for providing assistance functions of the vehicle assistance system 100. According to the embodiment, the vehicle assistance device 120 may be mounted inside or outside the vehicle 110 and connected to a data port of the vehicle 110 to receive the vehicle data.

The management server 130 may manage the operations of the vehicle assistance device 120 and the assistance functions of the vehicle assistance system 100. The management server 140 may exchange data with the vehicle assistance device 120 in a wired/wireless communication manner. According to the embodiment, the management server 130 may receive data obtained before and after a battery accident of the vehicle 110 and record the data in a database. Management software may be installed in the vehicle assistance device 120.

According to the embodiment, the management server 130 may be substituted for the vehicle assistance device 120 to perform the operations for the assistance functions of the vehicle assistance system 100. According to the embodiment, the vehicle assistance device 120 may perform the operations of managing and recording the data by executing the management software. The management server 130 may provide the vehicle assistance device 120 with update information of the management software.

According to the embodiment, the vehicle assistance device 120 may include a black box device and/or a navigation device installed in the vehicle 110. A black box for a vehicle in the related art provides only a recording function related to a vehicle accident without providing a separate recording means related to a battery accident of an electric vehicle or the like. According to the embodiment, the vehicle assistance system 100 may add a vehicle data collection function to the black box device and the navigation device in the related art and provide a battery state notification function by means of an algorithm thereof.

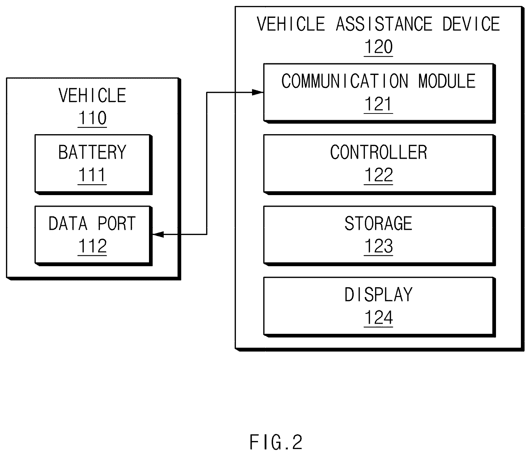

FIG. 2 is a view illustrating the elements constituting the vehicle assistance device according to some embodiments.

With reference to FIG. 2, the vehicle assistance device 120 may include a communication module 121, a controller 122, a storage 123, and a display 124. However, the present disclosure is not limited thereto. Some components may be excluded from the vehicle assistance device 120, or other universal components may be further included in the vehicle assistance device 120.

According to the embodiment, in the vehicle assistance device 120, the communication module 121, the controller 122, the storage 123, and the display 124 may be electrically connected to one another via a device-to-device communication method. The device-to-device communication method may include bus, general purpose input and output (GPIO), serial peripheral interface (SPI), mobile industry processor interface (MIPI), and the like.

The communication module 121 may be connected to a data port 112 of the vehicle 110. Therefore, the vehicle data may be provided to the vehicle assistance device 120. The vehicle data may include battery data related to a battery 111 of the vehicle 110. According to the embodiment, the vehicle data may include controller area network (CAN) communication data provided from an OBD terminal of the vehicle 110 through a wire harness.

The controller 122 may have a structure for executing instructions for implementing the operations of the vehicle assistance device 120. The controller 122 may be implemented as an array of a plurality of logic gates or a universal microprocessor for operating various types of computations, or the controller 122 may include a single processor or a plurality of processors. For example, the controller 122 may be implemented in the form of at least one of a microprocessor, a CPU, a GPU, and an AP.

The controller 122 may operate together with a memory configured to store various types of data, instructions, software, mobile applications, computer programs, and the like. The memory may be configured separately from or integrally with the controller 122. The controller 122 may perform various types of computations by executing instructions stored in the memory. For example, the memory may be implemented as a non-volatile device, such as ROM, PROM, EPROM, EEPROM, flash memory, PRAM, MRAM, RRAM, or FRAM or implemented as a volatile device such as DRAM, SRAM, SDRAM, or PRAM.

The storage 123 may store the vehicle data provided from the vehicle 110 and store the battery data and the like derived by analyzing the vehicle data. The storage 123 may be implemented in the form of HDD, SSD, SD, Micro-SD, or a combination thereof. Particularly, the storage 123 may be implemented in the form of an SD card attachable to or detachable from the vehicle assistance device 120.

The communication module 121 may be configured to collect the vehicle data from the data port 112 of the vehicle 110. According to the embodiment, the communication module 121 may include the wire harness connected to an OBD port of the vehicle 110. The communication module 121 may collect CAN data of the vehicle 110.

The controller 122 may be configured to provide an image acquisition function of acquiring images of the surroundings of the vehicle 110 and a route guide function of guiding a traveling route of the vehicle 110. The image acquisition function may include a black box function for a vehicle, and the route guide function may include a navigation function for a vehicle.

The controller 122 may be configured to manage the battery data related to the battery 111 of the vehicle 110 by analyzing the vehicle data. The vehicle data may include the battery data such as voltage information, electric current information, and temperature information of the battery 111. The battery data may be used to analyze an accident such as an internal short circuit of the battery 111.

The storage 123 may be configured to store at least some of the battery data. When an abnormal pattern is detected from the battery data, the battery data acquired before and after the time point related to the abnormal pattern may be recorded. According to the embodiment, the battery data acquired before and after the time point at which the battery accident of the vehicle 110 occurs may be recorded, and the battery data may be subsequently taken into account to analyze the cause of the accident.

According to the embodiment, the controller 122 may be configured to determine whether an event related to the abnormal operation of the battery 111 occurs on the basis of the battery data. The controller 122 may be configured to record the battery data, which are acquired for a time section including an event occurrence time point, in the storage 123. The event related to the abnormal operation of the battery 111 may include an internal short circuit, battery overheating, damage caused by an external impact, and the like. When it is determined that the event occurs, the battery data may be recorded from a first time point before the occurrence time point to a second time point after the occurrence time point. For example, the battery data may include a voltage, an electric current, and a temperature for a pack, a module, and a cell of the battery 110 from the first time point to the second time point.

According to the embodiment, the controller 122 may be configured to determine whether a warning event or an emergency event related to the battery 111 occurs on the basis of a level of an abnormal operation. The controller 122 may be configured to record the battery data for a time section including an emergency event occurrence time point when the emergency event occurs. The events related to the abnormal operation may be divided into the warning event and the emergency event depending on a relative severity level. In case that the severer emergency event, a function of recording the battery data may be performed.

According to the embodiment, the controller 122 may be configured to compare measurement values of battery variables according to the battery data with a plurality of threshold values and determine a level of the abnormal operation as any one of a normal level, a warning level, and an emergency level, and the controller 122 may be configured to determine that the warning event or the emergency event occurs in response to the warning level or the emergency level. The battery variables may be a voltage, an electric current, a temperature, an SOC, an SOH, and the like. The battery variable may be compared with the plurality of threshold values and determined as any one of the normal level, the warning level, and the emergency level.

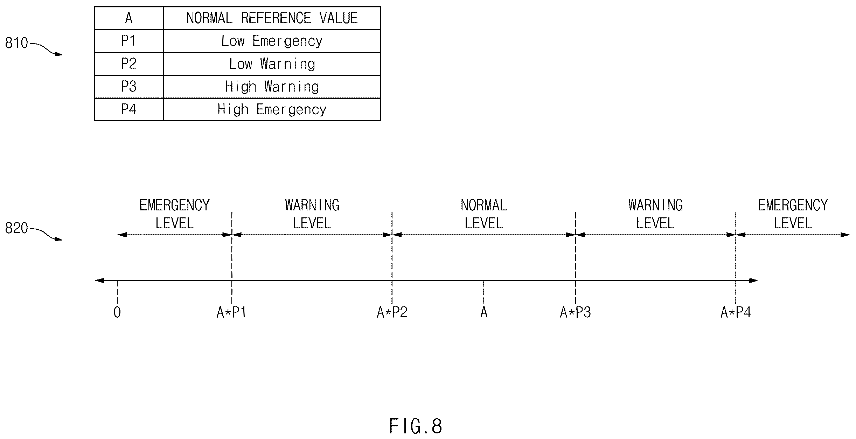

According to the embodiment, the controller 122 may be configured to calculate an emergency lower limit value, an emergency upper limit value, a warning lower limit value, and a warning upper limit value by multiplying a normal reference value of the battery variable by first to fourth parameters. The controller 122 may be configured to determine that the emergency event occurs when the measurement value of the battery variable is larger than the emergency lower limit value or smaller than the emergency lower limit value. The controller 122 may be configured to determine that the warning event occurs when the measurement value of the battery variable is larger than the warning lower limit value or smaller than the warning lower limit value. The normal reference value and the first to fourth parameters will be described with reference to FIG. 8 to be described below.

According to the embodiment, when the emergency event occurs, the controller 122 may be configured to back up the battery data, which are obtained for the time section including the emergency event occurrence time point, to the management server 130 of the vehicle assistance device 120 and a mobile terminal of a driver registered in the vehicle assistance device 120. For example, in the event of a fire in the vehicle 110, the storage 123 of the vehicle assistance device 120 mounted in the vehicle 110 may also be damaged. In order to prevent this situation, the data acquired before and after the accident may be backed up to the management server 130 and the driver's terminal.

According to the embodiment, the display 124 may be further included and configured to display a detailed description of the abnormal operation and an advisory message to the driver together with battery monitoring information according to the battery data when the warning event or the emergency event occurs. The display 124 various LCD and LED devices and the like capable of displaying visual information. The display 124 may display the battery monitoring information. The display 124 may additionally display the detailed description of the abnormal operation and the advisory message when the event occurs.

According to the embodiment, the controller 122 may be configured to receive information related to the detailed description from a management module of the battery 111 and display, to the driver, identification information of a battery unit of the battery 111, in which the abnormal operation occurs, the type of battery variable related to the abnormal operation, and a difference between the measurement value of the battery variable and a normal value on the basis of the information related to the detailed description. The battery 111 may include the battery units and the management module. The battery units may be a battery cell, a battery module, a battery pack, and the like. According to the embodiment, the vehicle assistance device 120 may communicate with the management module of the battery 111 by an appropriate method such as near-field communication. When the detailed description is provided from the management module, which abnormality occurs in which variable in which battery unit may be displayed to the driver.

According to the embodiment, the controller 122 may be configured to derive detailed management information of the battery 111 including state-of-charge (SOC) information, state-of-health information, and state scores on the basis of the battery data by means of battery management software from the management server 130 of the vehicle assistance device 120, and the controller 122 may be configured to display the detailed management information on the display 124. The detailed management information may be calculated by a management algorithm of the battery management software. The SOC information of the detailed management information may be more precise than estimated SOC information provided by the vehicle 110. The state-of-health information and the state score cannot be provided by the vehicle 110. According to the embodiment, the battery management software installed in the vehicle assistance device 120 may be consistently updated by the management server 130.

According to the embodiment, the controller 122 may be configured to provide the battery data to the management server 130 of the vehicle assistance device 120 and display, on the display 124, the detailed management information of the battery 110 including state-of-charge (SOC) information, state-of-health information, and state scores provided from the management server 130. Instead of the method of calculating the detailed management information directly by the vehicle assistance device 120 by means of the battery management software, a method of receiving the detailed management information calculated by the management server 130 may be adopted. Therefore, there may be advantages in terms of computational burden or hardware specifications of the vehicle assistance device 120.

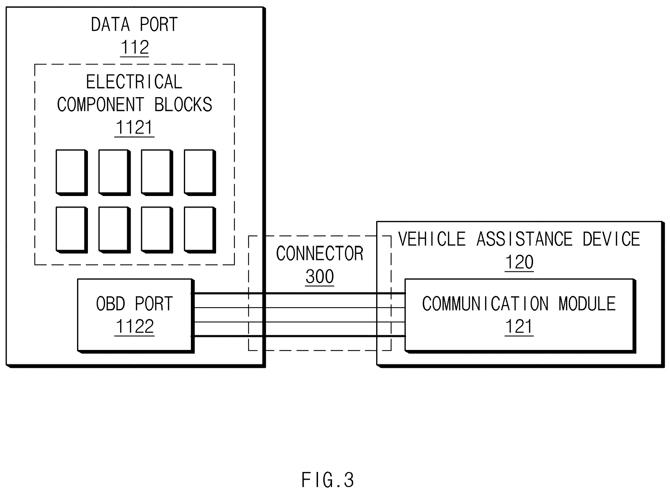

FIG. 3 is a view illustrating a structure in which the vehicle assistance device according to some embodiments is connected to the vehicle.

FIG. 3 may illustrate a structure in which the communication module 121 of the vehicle assistance device 120 and the data port 112 of the vehicle 110 are connected. The data port 112 of the vehicle 110 may include a plurality of electrical component blocks 1121 and an OBD port 1122.

The plurality of electrical component blocks 1121 may include various electrical component functions of the vehicle 110, e.g., connector blocks related to an audio function, an air conditioning function, a lighting function, and the like. According to the embodiment, the plurality of electrical component blocks 1121 may include a fuse box of the vehicle 110.

The OBD port 1122 may be connected to the communication module 121 through a connector 300. According to the embodiment, the connector 300 may include the wire harness. A black box device or a navigation device in the related art may be connected to the plurality of electrical component blocks 1121, whereas the vehicle assistance device 120 may be connected to the OBD port 1122. Therefore, the vehicle assistance device 120 may approach the vehicle data and the battery data.

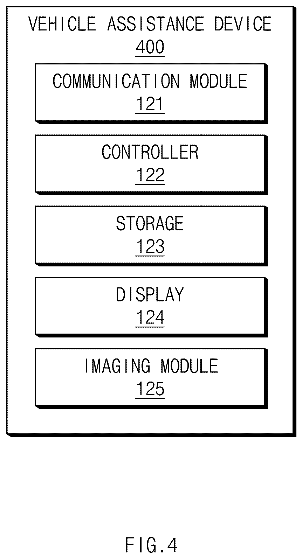

FIG. 4 is a view illustrating the black box function of the vehicle assistance device according to some embodiments.

With reference to FIG. 4, a vehicle assistance device 400 may further include an imaging module 125 in addition to the communication module 121, the controller 122, the storage 123, and the display 124. According to the embodiment, the vehicle assistance device 400 may include a black box device installed in the vehicle 110.

The vehicle assistance device 400 may provide an image acquisition function of acquiring images of the surroundings of the vehicle 110. In addition to the image acquisition function, a battery black box function for recording the battery data acquired before and after a time point of an accident when the accident of the battery 111 occurs may be additionally provided.

The imaging module 125 may include a camera device for capturing images of the surroundings of the vehicle 110. The imaging module 125 may be positioned at a position at which the imaging module 125 captures images of a front side, a rear side, and/or a lateral side of the vehicle 110. According to the embodiment, the vehicle assistance device 400 may further include an acceleration sensor configured to detect an impact on the vehicle 110. When an impact is detected by the acceleration sensor, images/videos of the surroundings before and after a time point of the impact may be recorded.

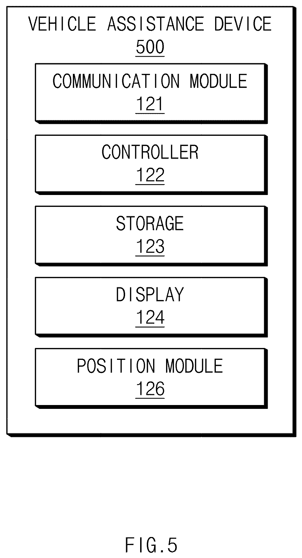

FIG. 5 is a view illustrating a navigation function of the vehicle assistance device according to some embodiments.

With reference to FIG. 5, a vehicle assistance device 500 may further include a position module 126 in addition to the communication module 121, the controller 122, the storage 123, and the display 124. According to the embodiment, the vehicle assistance device 500 may include a navigation device installed in the vehicle 110.

The vehicle assistance device 500 may provide a route guide function of guiding a traveling route of the vehicle 110. In addition to the route guide function, the battery black box function for recording the battery data acquired before and after a time point of an accident when the accident of the battery 111 occurs may be additionally provided.

The position module 126 may include a GPS module. The vehicle assistance device 500 may guide, in real time, a traveling route from a current position to a target position of the vehicle 110 on the basis of GPS position information of the vehicle 110 and map information. The vehicle assistance device 500 may additionally provide a voice notification function, a traveling pattern analysis function, and the like.

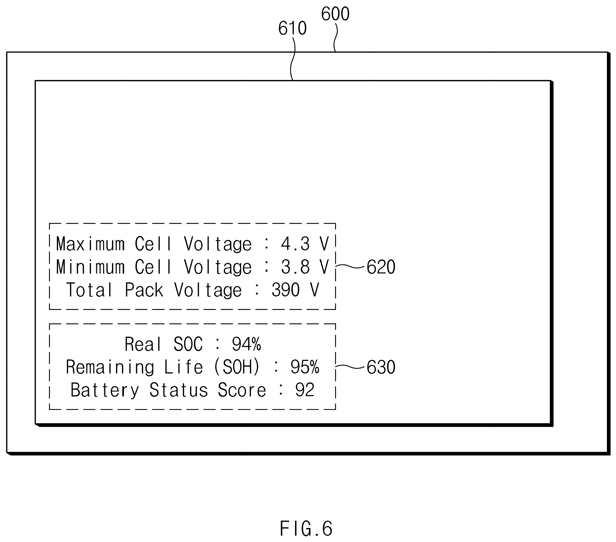

FIG. 6 is a view illustrating a method of displaying battery monitoring information and detailed management information on a display of the vehicle assistance device according to some embodiments.

With reference to FIG. 6, a display 600 of the vehicle assistance device may display battery monitoring information 620 and detailed management information 630 through a screen region 610. The vehicle assistance device may further include a power button, various function buttons, and the like around the screen region 610.

The battery monitoring information 620 may include information on a maximum cell voltage, a minimum cell voltage, an overall voltage of the pack, and the like. The vehicle data and the battery data may be collected from the vehicle 110 through CAN communication, and some of the collected data may be displayed as the battery monitoring information 620 on the display 600.

The detailed management information 630 may include information such as a real SOC, a state of health (SOH), and a battery state score. According to the embodiment, the real SOC may have higher accuracy than SOC information of the battery 111 provided by the vehicle 110. For example, the real SOC may be calculated by the battery management software managed by the management server 130 and calculated on the basis of more detailed battery data provided from the management module of the battery 111.

The battery management software may additionally calculate a state of health (SOH) and a battery state score. In particular, because algorithms of the battery management software may be consistently updated to the latest version by the management server 130, the accuracy of the detailed management information 630 may be maintained. According to the embodiment, the battery management software may be updated in an over-the-air (OTA) manner.

According to the embodiment, the battery monitoring information 620 and/or the detailed management information 630 may be provided to the driver of the vehicle 110 by means of a voice instead of being visually displayed on the display 600. According to the embodiment, the battery monitoring information 620 and/or the detailed management information 630 may be provided by means of a mobile application executed by the mobile terminal of the driver.

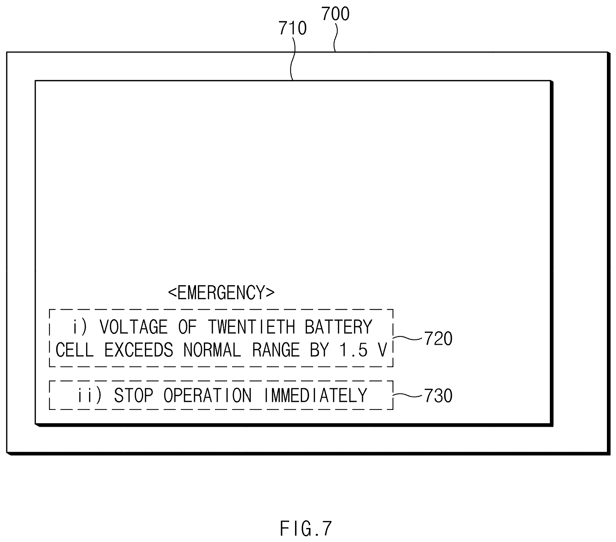

FIG. 7 is a view illustrating a method of displaying a detailed description of an abnormal operation and an advisory message on the display of the vehicle assistance device according to some embodiments.

With reference to FIG. 7, a display 700 of the vehicle assistance device may display a detailed description 720 of the abnormal operation and an advisory message 730 to a driver through a screen region 710.

The detailed description 720 of the abnormal operation may include identification information of the battery unit, in which the abnormal operation occurs, the type of battery variable, and a difference between the measurement value and the normal value. The identification information of the battery unit may indicate which cell, module, or pack of the battery 111 is abnormal. The type of battery variable may be a voltage, an electric current, a temperature, an SOC, an SOH, and the like. In comparison with a case in which a notification indicating that the battery 111 is abnormal is merely provided, the detailed description 720 may intuitively provide the driver with a specific abnormal state of the battery 111.

The advisory message 730 may include a message advising to stop the operation. According to the embodiment, the advisory message 730 may vary depending on the type of event related to the abnormal operation of the battery 111. In the case of the emergency event, the advisory message 730 may include the operation stopping advisory message and further include a message advising to immediately stop the vehicle 110. In the case of the warning event, the advisory message may include a message advising to reduce a speed of the vehicle 110 and a message advising the vehicle 110 to visit a garage.

FIG. 8 is a view illustrating a process of determining a level of the abnormal operation by comparing the measurement value of the battery variable with the plurality of threshold values according to some embodiments.

FIG. 8 may illustrate a table 810 showing a normal reference value A and first to fourth parameters P1, P2, P3, and P4 for calculating the plurality of threshold values and illustrate a graph 820 for distinguishing the abnormal operation of the battery 111 based on the plurality of threshold values.

The normal reference value A may refer to a value in a case in which the battery variables, such as the voltage, the electric current, the temperature, the SOC, and the SOH, are in normal states. The plurality of threshold values may be calculated by multiplying the normal reference value A by the first to fourth parameters P1, P2, P3, and P4. The first parameter P1 may be a parameter for calculating a first boundary value (A*P1) related to the emergency level. The second parameter P2 may be a parameter for calculating a second boundary value (A*P2) related to the warning level. The third parameter P3 may be a parameter for calculating a third boundary value (A*P3) related to the warning level. The fourth parameter P4 may be a parameter for calculating a fourth boundary value (A*P4) related to the emergency level.

In the graph 820, in case that the measurement value of the battery variable is smaller than the first boundary value (A*P1), the abnormal operation of the battery 111 may be determined as the emergency level. In case that the measurement value of the battery variable is present between the first boundary value (A*P1) and the second boundary value (A*P1), the abnormal operation of the battery 111 may be determined as the warning level.

In case that the measurement value of the battery variable is present between the second boundary value (A*P2) and the third boundary value (A*P3), the abnormal operation of the battery 111 may be determined as the normal level. In case that the measurement value of the battery variable is present between the third boundary value (A*P3) and the fourth boundary value (A*P4), the abnormal operation of the battery 111 may be determined as the warning level. In case that the measurement value of the battery variable is larger than the fourth boundary value (A*P4), the abnormal operation of the battery 111 may be determined as the emergency level.

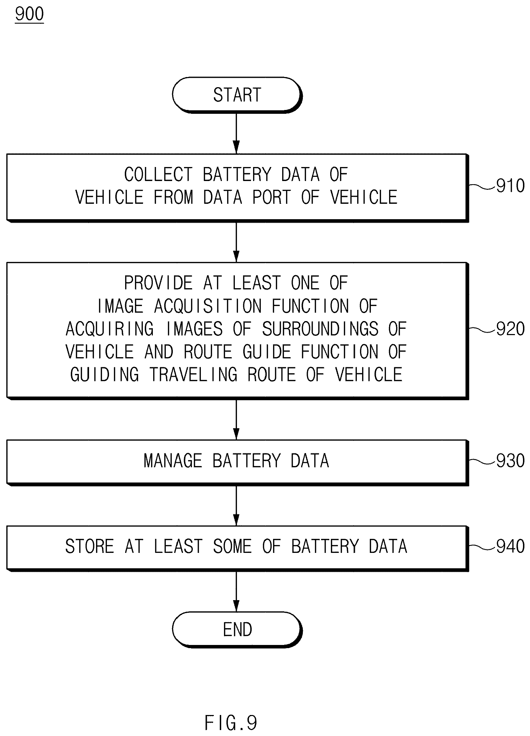

FIG. 9 is a view illustrating steps constituting a method of operating the vehicle assistance device according to some embodiments.

With reference to FIG. 9, a method 900 of operating the vehicle assistance device may include steps 910, 920, 930, and 940. However, the present disclosure is not limited thereto. Some steps may be excluded, or other universal steps may be added. The steps of the operating method 900 may be performed in the order different from the illustrated order.

The method 900 of operating the vehicle assistance device may include steps performed in a time series manner in the vehicle assistance device 120. Therefore, the above-mentioned description of the vehicle assistance device 120 may be equally applied even to the operating method 900 even though the above-mentioned description is omitted below.

Steps 910, 920, 930, and 940 of the method 900 of operating the vehicle assistance device may be performed by the communication module 121, the controller 122, the storage 123, and the display 124 of the vehicle assistance device 120.

In step 910, the vehicle assistance device 120 may collect the battery data of the vehicle from the data port of the vehicle.

In step 920, the vehicle assistance device 120 may provide at least one of the image acquisition function of acquiring images of the surroundings of the vehicle and the route guide function of guiding the traveling route of the vehicle.

In step 930, the vehicle assistance device 120 may manage the battery data related to the battery of the vehicle by analyzing the vehicle data.

In step 940, the vehicle assistance device 120 may store at least some of the battery data.

According to the embodiment, the method 900 of operating the vehicle assistance device may be implemented in the form of a computer program stored in a computer-readable storage medium. That is, the computer program may include instructions for implementing the operating method 900, the instructions of the program may be stored in the computer-readable storage medium. The computer program may include a mobile application.

According to the embodiment, the computer-readable storage media may include magnetic media, such as a hard disk, a floppy disk, and a magnetic tape, optical media, such as CD-ROM and DVD, magneto-optical media, such as a floptical disk, and hardware devices, such as a ROM, a RAM, and a flash memory, which are specifically configured to store and execute program instructions. The computer program instructions may include machine codes, which are produced by a compiler, and higher level codes that may be executed by a computer using an interpreter.

Unless explicitly described to the contrary, the words "comprise," "include," or "have" and variations such as "comprises," "comprising," "includes," "including," has," or "having," should be understood to imply the inclusion of stated elements but not the exclusion of any other elements. Unless otherwise defined, all terms including technical or scientific terms may have the same meaning as commonly understood by those skilled in the art to which the embodiments disclosed in the present document pertain. The terms such as those defined in a commonly used dictionary may be interpreted as having meanings consistent with meanings in the context of related technologies and may not be interpreted as ideal or excessively formal meanings unless explicitly defined in the present document.

The above description is simply given for illustratively describing the technical spirit disclosed in the present embodiment, and those skilled in the art to which the embodiments disclosed in the present document pertain will appreciate that various changes and modifications are possible without departing from the essential characteristics of the embodiments disclosed in the present document. Therefore, the embodiments disclosed in the present document are provided for illustrative purposes only but are not intended to limit the technical concept of the embodiments disclosed in the present document. The scope of the technical spirit disclosed in the present document is not limited by the embodiment. The protective scope of the technical spirit disclosed in the present document should be construed based on the appended claims, and all the technical spirit in the equivalent scope thereto should be construed as falling within the scope of the present document.

### [Description of Reference Numerals]

| | | | |
|---|---|---|---|
| 100: | Vehicle assistance system | 110: | Vehicle |
| 120: | Vehicle assistance device | 121: | Communication module |
| 122: | Controller | 123: | Storage |
| 124: | Display | 130: | Management server |

## Claims

1. A vehicle assistance device comprising:
a communication module configured to collect battery data of a vehicle from a data port of the vehicle;
a controller configured to manage the battery data and provide at least one of an image acquisition function of acquiring images of surroundings of the vehicle and a route guide function of guiding a traveling route of the vehicle; and
a storage configured to store at least some of the battery data.

2. The vehicle assistance device of claim 1, wherein the controller is configured to determine whether an event related to an abnormal operation of the battery occurs on the basis of the battery data, and
wherein the controller is configured to record the battery data for a time section including an event occurrence time point in the storage.

3. The vehicle assistance device of claim 2, wherein the controller is configured to determine whether a warning event or an emergency event related to the battery occurs on the basis of a level of the abnormal operation, and
wherein the controller is configured to record the battery data for a time section including an emergency event occurrence time point when the emergency event occurs.

4. The vehicle assistance device of claim 3, wherein the controller is configured to compare a measurement value of a battery variable according to the battery data with a plurality of threshold values and determine a level of the abnormal operation as any one of a normal level, a warning level, and an emergency level, and
wherein the controller is configured to determine that the warning event or the emergency event occurs in response to the warning level or the emergency level.

5. The vehicle assistance device of claim 4, wherein the controller is configured to calculate an emergency lower limit value, an emergency upper limit value, a warning lower limit value, and a warning upper limit value by multiplying a normal reference value of the battery variable by first to fourth parameters,
wherein the controller is configured to determine that the emergency event occurs when the measurement value of the battery variable is larger than the emergency lower limit value or smaller than the emergency lower limit value, and
wherein the controller is configured to determine that the warning event occurs when the measurement value of the battery variable is larger than the warning lower limit value or smaller than the warning lower limit value.

6. The vehicle assistance device of claim 3, wherein the controller is configured to back up the battery data for the time section including the emergency event occurrence time point to a management server of the vehicle assistance device and a mobile terminal of a driver registered in the vehicle assistance device when the emergency event occurs.

7. The vehicle assistance device of claim 3, further comprising:
a display configured to display a detailed description of the abnormal operation and an advisory message to a driver together with battery monitoring information according to the battery data when the warning event or the emergency event occurs.

8. The vehicle assistance device of claim 7, wherein the controller is configured to receive information on the detailed description from a management module of the battery, and
wherein the controller is configured to display, to the driver, identification information of a battery unit of the battery, in which the abnormal operation occurs, a type of battery variable related to the abnormal operation, and a difference between a measurement value of the battery variable and a normal value on the basis of the information on the detailed description.

9. The vehicle assistance device of claim 7, wherein the controller is configured to derive detailed management information of the battery including state-of-charge (SOC) information, state-of-health information, and a state score on the basis of the battery data by means of battery management software provided from a management server of the vehicle assistance device and display the detailed management information on the display.

10. The vehicle assistance device of claim 7, wherein the controller is configured to provide the battery data to a management server of the vehicle assistance device and display, on the display, detailed management information of the battery including state of charge (SOC) information, state-of-health information, and a state score provided from the management server.

11. A method of operating a vehicle assistance device, the method comprising:
collecting battery data of a vehicle from a data port of the vehicle;
providing at least one of an image acquisition function of acquiring images of surroundings of the vehicle and a route guide function of guiding a traveling route of the vehicle;
managing the battery data; and
storing at least some of the battery data.

12. The method of claim 11, wherein the storing of at least some of the battery data comprises:
determining whether an event related to an abnormal operation of the battery occurs on the basis of the battery data; and
recording the battery data for a time section including an event occurrence time point in the storage.

13. The method of claim 12, wherein the recording of the battery data comprises:
determining whether a warning event or an emergency event related to the battery occurs on the basis of a level of the abnormal operation; and
recording the battery data for a time section including an emergency event occurrence time point when the emergency event occurs.

14. The method of claim 13, wherein the determining of whether the warning event or the emergency event occurs comprises:
comparing a measurement value of a battery variable according to the battery data with a plurality of threshold values and determining a level of the abnormal operation as any one of a normal level, a warning level, and an emergency level; and
determining that the warning event or the emergency event occurs in response to the warning level or the emergency level.

15. The method of claim 14, wherein the determining of whether the warning event or the emergency event occurs comprises:
calculating an emergency lower limit value, an emergency upper limit value, a warning lower limit value, and a warning upper limit value by multiplying a normal reference value of the battery variable by first to fourth parameters; and
determining that the emergency event occurs when the measurement value of the battery variable is larger than the emergency lower limit value or smaller than the emergency lower limit value, and determining that the warning event occurs when the measurement value of the battery variable is larger than the warning lower limit value or smaller than the warning lower limit value.

16. The method of claim 13, wherein the recording of the battery data comprises backing up the battery data for the time section including the emergency event occurrence time point to a management server of the vehicle assistance device and a mobile terminal of a driver registered in the vehicle assistance device when the emergency event occurs.

17. The method of claim 13, further comprising:
displaying a detailed description of the abnormal operation and an advisory message to a driver together with battery monitoring information according to the battery data when the warning event or the emergency event occurs.

18. The method of claim 17, wherein the displaying comprises:
receiving information on the detailed description from a management module of the battery; and
displaying, to the driver, identification information of a battery unit of the battery, in which the abnormal operation occurs, a type of battery variable related to the abnormal operation, and a difference between a measurement value of the battery variable and a normal value on the basis of the information on the detailed description.

19. The method of claim 17, wherein the displaying comprises:
deriving detailed management information of the battery including state of charge (SOC) information, state-of-health information, and a state score on the basis of the battery data by means of battery management software provided from a management server of the vehicle assistance device; and
displaying the detailed management information on the display.

20. The method of claim 17, wherein the displaying comprises:
providing the battery data to a management server of the vehicle assistance device; and
displaying, on the display, detailed management information of the battery incl uding state of charge (SOC) information, state-of-health information, and a state score provided from the management server
